(19) Europäisches Patentamt / European Patent Office / Office européen des brevets

(11) **EP 3 425 385 A1**

(12) **DEMANDE DE BREVET EUROPEEN**

(43) Date de publication:
**09.01.2019 Bulletin 2019/02**

(21) Numéro de dépôt: **18180544.1**

(22) Date de dépôt: **28.06.2018**

(51) Int Cl.:
*G01N 29/036* (2006.01)   *G01N 29/04* (2006.01)
*G01N 29/14* (2006.01)   *G01N 29/22* (2006.01)
*G01N 29/38* (2006.01)   *G01N 29/44* (2006.01)
*G01N 29/46* (2006.01)   *G01N 29/50* (2006.01)
*G01R 31/12* (2006.01)   *G01R 31/327* (2006.01)
*H01H 33/56* (2006.01)   *G01M 3/00* (2006.01)

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **04.07.2017 FR 1756298**

(71) Demandeurs:
• **Commissariat à l'Énergie Atomique
  et aux Énergies Alternatives
  75015 Paris (FR)**
• **Schneider Electric Industries SAS
  92500 Rueil-Malmaison (FR)**

(72) Inventeurs:
• **ALBERTO, Diego
  38054 GRENOBLE Cedex 09 (FR)**
• **HEIRIES, Vincent
  38054 GRENOBLE Cedex 09 (FR)**
• **PERICHON, Pierre
  38054 GRENOBLE Cedex 09 (FR)**
• **TOUFFLET, Raphael
  38054 GRENOBLE Cedex 09 (FR)**
• **PREVE, Christophe
  92500 RUEIL-MALMAISON (FR)**
• **SAKER, Abdou
  92500 RUEIL-MALMAISON (FR)**
• **BARBA JIMENEZ, Eduardo
  92500 RUEIL-MALMAISON (FR)**

(74) Mandataire: **GIE Innovation Competence Group
310, avenue Berthelot
69372 Lyon Cedex 08 (FR)**

(54) **PROCEDE DE DETERMINATION D'UNE PROPORTION D'AIR DANS UN CONTENEUR**

(57) L'invention concerne un procédé de détermination d'une proportion d'air dans un conteneur (40), le procédé comprenant :
-la fourniture d'un équipement électrique (4) comprenant un conteneur étanche (40) contenant un gaz isolant (41), le conteneur (4) comportant une paroi flexible (401) formant membrane d'étanchéité ;
-l'application d'un choc sur le conteneur de façon à exciter la paroi flexible ;
-la mesure (2) d'un signal acoustique à l'extérieur du conteneur après le choc ;
-l'identification (1) de l'instant du choc dans ledit signal acoustique mesuré ;
-la comparaison (1) du signal acoustique après l'instant du choc identifié, à un signal acoustique de référence correspondant à un mélange gazeux présentant une proportion prédéfinie d'air et dudit gaz isolant ;
-la détermination que le gaz dans le conteneur présente la proportion prédéfinie d'air et de gaz isolant à partir de la comparaison entre le signal acoustique mesuré et le signal acoustique de référence.

Fig. 1

**Description**

L'invention concerne d'une manière générale des équipements électriques tels que des interrupteurs, des sectionneurs, des disjoncteurs ou des réenclencheurs, et en particulier les équipements électriques pour réseaux électriques de haute tension à l'intérieur desquels se trouvent des gaz isolants tels que du $SF_6$. Dans le présent document, le terme "haute tension" regroupe les réseaux électriques d'une tension supérieure ou égale à 1000V.

Pour des raisons de sécurité, certains équipements électriques ont pour fonction d'établir et d'interrompre le courant dans un circuit électrique selon des conditions fixées par des normes. La coupure d'un courant électrique par un disjoncteur en haute tension est obtenue en séparant des contacts dans un gaz ou dans un milieu isolant. Après séparation des contacts de l'équipement électrique, on souhaite éviter que le courant continue de circuler dans le circuit à travers un arc électrique qui s'est établi entre ces contacts.

Un certain nombre d'équipements électriques haute tension placent les contacts électriques dans un gaz isolant, c'est-à-dire un gaz ayant de bonnes propriétés d'isolation électrique et préférentiellement également des propriétés de coupure électrique. Un tel gaz sera dénommé dans la suite du document "gaz isolant".

En particulier, il est connu de loger des contacts d'un équipement électrique dans un conteneur étanche, rempli d'un gaz isolant sous pression, tel que du $SF_6$. Le $SF_6$ est un gaz qui a notamment l'avantage de présenter une grande rigidité diélectrique et une grande stabilité en présence d'un arc électrique.

D'autres équipements électriques tels que des transformateurs utilisent également un tel gaz isolant dans un conteneur, pour ses propriétés d'isolation électrique.

Un grand nombre d'équipements électriques de ce type sont actuellement en service. En cas de fuite du conteneur, le gaz isolant s'échappe progressivement, ce qui constitue un risque environnemental, le $SF_6$ étant un gaz à effet de serre. De plus, ses produits de décomposition, provenant des interactions avec les arcs électriques, présentent une certaine toxicité. Par ailleurs, lorsque la pression de gaz à l'intérieur du conteneur devient équivalente à la pression atmosphérique, le gaz isolant est progressivement remplacé par de l'air ambiant. Ainsi, l'équipement électrique peut se trouver dans une situation où il est incapable d'interrompre un arc électrique, et donc incapable d'assurer sa fonction de coupure de façon satisfaisante. Dans de telles conditions, le maintien de l'arc électrique peut conduire à un incendie de l'équipement électrique.

La connaissance de la quantité de gaz isolant encore stockée à l'intérieur du conteneur de l'équipement électrique est ainsi primordiale afin de déterminer si celui-ci est encore fonctionnel. Une telle connaissance est par exemple primordiale pour permettre à des techniciens de réaliser une coupure et d'avoir la garantie de pouvoir intervenir sans risque au niveau de l'équipement électrique.

Des solutions connues d'estimation de la quantité de gaz isolant dans le conteneur d'un équipement électrique reposent sur un prélèvement de gaz dans le conteneur, suivi d'une analyse par un spectromètre de masse. De telles solutions nécessitent ainsi l'ouverture du conteneur, induisant des risques pour son étanchéité et des risques pour la création de nouvelles fuites. Un tel prélèvement nécessite au préalable une isolation de l'équipement électrique par rapport au réseau, ce qui nuit à la continuité de service. Un tel prélèvement nécessite également une analyse par un spectromètre de masse, qui n'est pas forcément disponible dans certaines zones géographiques ou dans certains environnements. De telles solutions sont donc relativement délicates à mettre en oeuvre sur des équipements électriques déjà déployés.

Une autre solution répandue pour connaître la quantité de gaz isolant consiste à placer de manière permanente ou occasionnelle un manomètre ou un densimètre. L'inconvénient de ces capteurs est que leur installation est une source de risque de fuite, raison pour laquelle ils ne sont pas installés systématiquement.

Le document WO2011119335 décrit un procédé de détermination d'une proportion volumique de gaz dans un réservoir de stockage de liquide. Ce document nécessite l'immersion d'un capteur dans le liquide de la cuve. Un tel procédé suppose de permettre au capteur de pouvoir communiquer à l'extérieur. Un tel capteur est également mal adapté pour mettre à niveau des cuves déjà existantes : il faut en effet arrêter et ouvrir la cuve, ce qui est une opération complexe. En outre, il n'est pas garanti de pouvoir monter un tel capteur pour n'importe quel type de cuve. Le capteur peut s'avérer inadapté pour une cuve d'équipement électrique en présence de forts champs électriques. En cas de défaillance du capteur présent dans la cuve, il peut s'avérer impossible d'y accéder pour assurer sa remise en service. Ce procédé est par ailleurs inadapté pour déterminer la proportion respective de deux gaz différents dans le réservoir de stockage.

L'invention vise à résoudre un ou plusieurs de ces inconvénients. Il existe notamment un besoin pour un dispositif de détermination de la proportion de gaz isolant dans un conteneur d'un équipement électrique de sécurité, susceptible d'être mis en oeuvre avec un appareillage simple et dans des environnements difficiles, et ce de manière non intrusive. L'invention porte ainsi sur un procédé de détermination d'une proportion d'air dans un conteneur, tel que défini dans la revendication 1.

L'invention porte également sur les variantes des revendications dépendantes. L'homme du métier comprendra que chacune des caractéristiques des revendications dépendantes peut être combinée indépendamment aux caractéristiques d'une revendication indépendante, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique d'un conteneur et d'un dispositif de détermination d'une proportion d'air selon un exemple de mise en oeuvre de l'invention ;
- la figure 2 illustre une mesure de signal acoustique en réponse à des chocs et un spectrogramme temporel de ce signal pour la mise en oeuvre d'un procédé selon un premier mode de réalisation de l'invention ;
- la figure 3 illustre des zones spécifiques du spectrogramme de la figure 2, pour un procédé de détermination selon le premier mode de réalisation ;
- la figure 4 illustre une portion particulière d'un spectrogramme de signal acoustique mesuré ;
- les figures 5 à 8 illustrent des spectrogrammes de référence pour différentes compositions à l'intérieur du conteneur ;
- les figures 9 à 12 illustrent des résultats de corrélation bidimensionnelle entre des spectrogrammes temporels de référence et des spectrogrammes temporels réalisés pour plusieurs chocs dans un cas particulier ;
- la figure 13 illustre un exemple de décomposition spectrale d'un signal acoustique mesuré en puissance, en vue de mettre en oeuvre un procédé de détermination selon un deuxième mode de réalisation ;
- la figure 14 illustre la sommation de la puissance acoustique en fonction de la fréquence, pour différents exemples de référence d'une première conception de conteneur ;
- la figure 15 illustre la sommation de la puissance acoustique en fonction de la fréquence, pour différents exemples de référence d'une deuxième conception de conteneur ;
- la figure 16 illustre la sommation de la puissance acoustique en fonction de la fréquence, pour différents exemples de référence d'une autre conception de conteneur ;
- la figure 17 illustre un diagramme de proportion de gaz diélectrique en fonction d'une sommation de puissance acoustique mesurée, en fonction de la fréquence, extrapolé du diagramme de la figure 16.

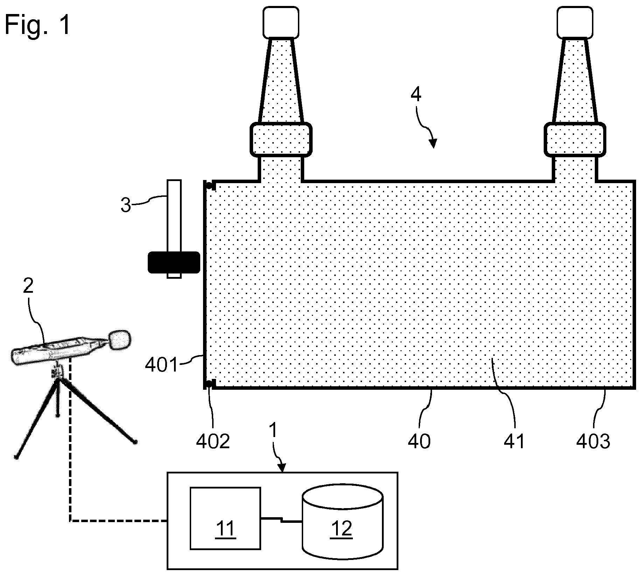

La figure 1 est une représentation schématique d'un équipement électrique 4 muni d'un conteneur étanche 40 et d'un dispositif de détermination d'une proportion d'air selon un exemple de mise en oeuvre de l'invention.

L'équipement électrique 4 est par exemple un sectionneur électrique, l'invention s'appliquant bien entendu à d'autres types d'équipement, par exemple des transformateurs électriques, des disjoncteurs, ou des interrupteurs. Le conteneur 40 peut contenir par exemple des composants électriques non illustrés, soumis à des tensions élevées. Dans cette application, pour éviter le maintien d'arcs électriques, le conteneur 40 est rempli d'un gaz isolant 41. Le gaz isolant 41 entoure les composants électriques de l'équipement électrique 4. Le gaz isolant 41 est maintenu en surpression dans le conteneur 40 par rapport à la pression atmosphérique. Le conteneur 40 est destiné à conserver le gaz isolant 41 de façon étanche, d'une part pour éviter des fuites de ce gaz isolant 41 vers l'extérieur, et d'autre part pour éviter l'entrée de gaz étranger dans le conteneur 40, ce qui pourrait nuire aux qualités de protection électrique du dispositif 4.

Le conteneur 40 présente une paroi flexible 401, fixée par exemple par des soudures 402 à un châssis 403 du conteneur 40. Les soudures 402 peuvent également être utilisées pour garantir l'étanchéité de l'intérieur du conteneur 40. Une telle paroi flexible 401 permet par exemple un accès à l'intérieur du conteneur 40 durant l'assemblage du dispositif 4, avant la fixation de cette paroi 401 au châssis 403. La paroi 401 forme une membrane d'étanchéité pour le gaz isolant 41 présent dans le conteneur 40. Avec une soudure 402 sur toute la périphérie de la paroi 401, la paroi 401 peut être considérée comme une membrane encastrée avec le châssis 403 du conteneur 40 sur toute sa périphérie.

La propriété de flexibilité de la paroi 401 n'est généralement pas une caractéristique fonctionnelle d'un équipement électrique 4 mais cette propriété sera exploitée par la suite pour déterminer la proportion d'air à l'intérieur du conteneur 40. La paroi flexible 401 est typiquement formée en métal, en particulier en acier inoxydable. La paroi flexible 401 peut également être réalisée en d'autres matériaux, par exemple et de façon non limitative en résine époxyde ou en résine polyuréthane, renforcée éventuellement par des fibres.

L'invention vise à permettre de déterminer une proportion d'air dans le gaz présent dans le conteneur 40, notamment pour déterminer si la proportion de gaz isolant 41 est encore suffisante pour présenter une fonction de protection de l'équipement électrique 4. Le gaz isolant 41 présente une rigidité diélectrique plus grande que celle de l'air, typiquement une rigidité diélectrique au moins 2 fois supérieure à celle de l'air. Le gaz isolant 41 pourra par exemple être du $SF_6$, dont la rigidité diélectrique est 2,5 fois supérieure à celle de l'air. Dans le cadre de l'invention, d'autres gaz isolants sont envisageables à la place du $SF_6$, comme par exemple l'hydrofluoropropène HFO1234ze, le Fluorocétone C5 mélangé avec du $CO_2$ et le Fluoronitrile C4 mélangé avec du $CO_2$.

Le dispositif de détermination de la proportion d'air dans le conteneur 40 comprend ici :

- un outil 3 destiné à appliquer un choc sur la paroi flexible 401, typiquement un maillet ;
- un microphone 2, positionné à proximité de la paroi flexible 401, de façon à mesurer le signal acoustique lors d'un choc de l'outil 3 sur cette paroi flexible 401 ;

- un dispositif de traitement 1, configuré pour récupérer et traiter le signal acoustique mesuré par le microphone 2. Le dispositif de traitement 1 comprend par exemple un circuit de traitement 11 et une base de données 12.

De façon générale, l'invention propose d'appliquer un choc sur la paroi flexible 401 (ou sur toute autre partie accessible et susceptible de faire vibrer cette paroi 401, par exemple une plaque métallique supérieure de la cuve) et de mesurer le signal acoustique à l'extérieur du conteneur 40 après l'application du choc. On peut ainsi réaliser cette mesure de signal acoustique sans risque pour l'opérateur, sans altérer l'intégrité de l'étanchéité du conteneur 40, et sans nécessiter un microphone 2 devant résister aux conditions de fonctionnement internes de l'équipement électrique 4. Un microphone 2 d'usage assez courant peut ainsi être utilisé pour réaliser la mesure du signal acoustique. Une telle mesure du signal acoustique peut également être réalisée en maintenant l'équipement électrique 4 en service. Le microphone 2 mesure ainsi le signal acoustique à proximité de l'équipement électrique 4 après l'application d'un choc.

Le dispositif de traitement 1 (par son circuit de traitement 11) récupère le signal acoustique mesuré par le microphone 2. Le dispositif de traitement 1 identifie ensuite l'instant du choc dans le signal acoustique mesuré. On peut par exemple envisager que le microphone 2 et le dispositif de traitement 1 soient intégrés dans un téléphone mobile tel qu'un smartphone, ce qui permet ainsi de mettre très simplement en oeuvre l'invention.

Le dispositif de traitement 1 compare ensuite le signal acoustique sur une période postérieure au choc identifié, à un signal acoustique de référence (mémorisé dans la base de données 12) correspondant à un mélange gazeux présentant une proportion prédéfinie d'air et du même gaz isolant 41. Selon l'invention, la comparaison du signal acoustique mesuré pourra inclure une ou plusieurs étapes de traitement ou de filtrage, pour comparer le signal traité ou filtré à un signal acoustique de référence.

L'invention tire parti des vibrations de la paroi flexible 401 suite au choc, du fait que la fréquence de résonance de la paroi flexible 401 varie en fonction de la proportion d'air dans le mélange gazeux incluant le gaz isolant 41. Par exemple, pour une paroi 401 en acier inoxydable d'une épaisseur de 1mm et de forme rectangulaire de 1,2m par 0,7m, la fréquence de résonance de la paroi 401 est approximativement de 30Hz.

Le dispositif de traitement 1 détermine que le mélange gazeux dans le conteneur 40 présente une proportion prédéfinie d'air et de gaz isolant 41, lorsque la comparaison du signal acoustique mesuré à un signal acoustique de référence présente une similitude suffisante. Une telle détermination peut ainsi être réalisée en fournissant un résultat quasiment en temps réel.

Le conteneur 40 forme comme une caisse de résonance avec un filtrage passe haut. En supposant que le conteneur ait une dimension interne de 1,2m par 0,7m par 0,3m, la fréquence de coupure en filtrage passe haut est de l'ordre de 50Hz.

Le gaz isolant 41 influence la réponse de la paroi 401 au choc qui lui est appliqué. Par exemple, le gaz $SF_6$ présente une masse molaire environ 5 fois supérieure à celle de l'air. Le déplacement du gaz isolant 41 est d'autant plus difficile et amorti à basse fréquence que la masse molaire de ce gaz est élevée.

La réponse acoustique au choc de la paroi 401 est donc impactée par les proportions respectives du gaz isolant 41 et de l'air dans le conteneur 40.

Un premier mode de réalisation de l'invention vise à garantir une faible sensibilité de la détermination de la proportion du mélange gazeux en fonction du type et de l'amplitude du choc appliqué sur la paroi 401. Le premier mode de réalisation s'avère en outre particulièrement précis avec une paroi 401 en acier inoxydable présentant une dureté Vickers comprise entre 160 et 200 HV, une dureté HRB (échelle de dureté Rockwell) comprise entre HRB 75 et HRB 80 et/ou un module d'élasticité compris entre 190 et 330 MPa, de préférence entre 200 et 330 MPa, par exemple du AISI 304L (ou X2CrNi18-09), présentant une dureté HRB79.

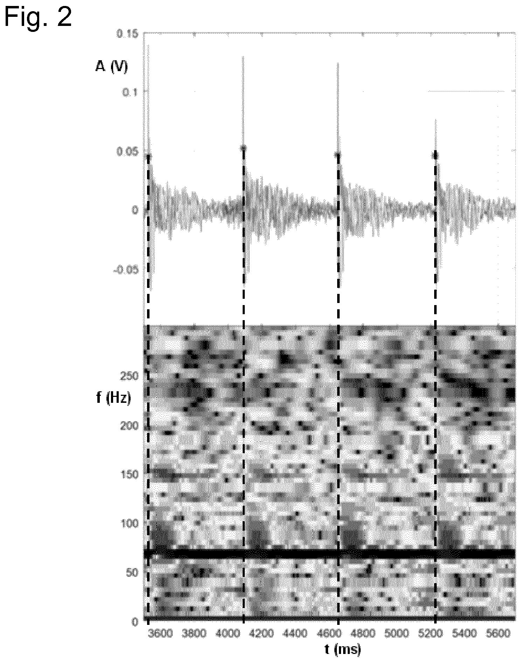

La figure 2 illustre :

- en partie haute, une amplitude d'un signal acoustique mesuré en réponse à plusieurs chocs successifs ;
- en partie basse, un spectrogramme temporel de ce signal mesuré. Le niveau de gris en un point du spectrogramme illustre l'amplitude pour une fréquence donnée à un instant donné.

Les lignes en trait discontinu correspondent aux instants où les chocs sont appliqués à la paroi 401.

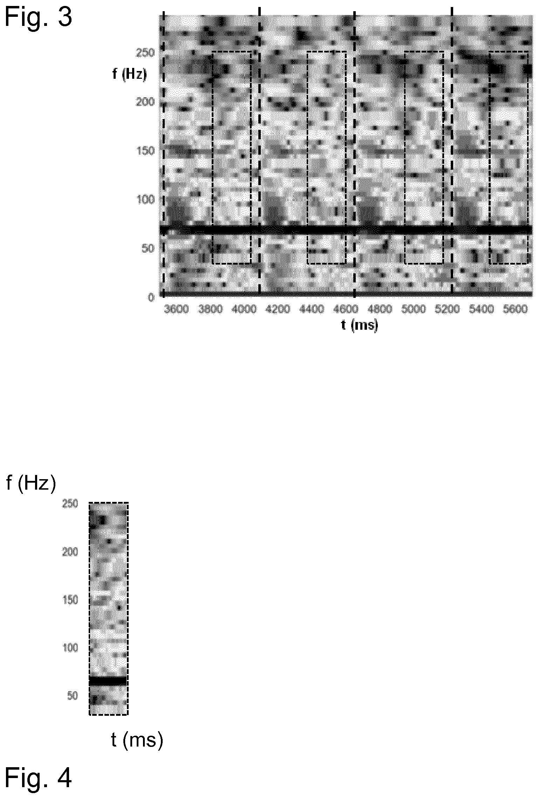

La figure 3 identifie plus précisément plusieurs zones dans un spectrogramme temporel du signal acoustique mesuré. Les inventeurs ont pu constater qu'après un choc, dans une première durée immédiatement après le choc, le spectrogramme temporel était assez dépendant des propriétés du choc, notamment de son amplitude.

A contrario, les inventeurs ont pu constater qu'après une certaine durée, le spectrogramme temporel du signal acoustique mesuré était relativement peu affecté par les propriétés du choc. Les propriétés de l'outil 3 ont une incidence assez réduite sur la qualité des résultats. Les inventeurs ont également pu constater que le spectrogramme temporel obtenu après cette durée était très représentatif de la proportion d'air dans un mélange d'air et du gaz isolant 41.

L'outil 3 est ici un maillet actionné manuellement. L'outil 3 peut aussi être un outil automatisé, par exemple fixé sur le conteneur 40 afin de pouvoir appliquer des chocs avec peu de dispersions.

Les inventeurs ont aussi pu déterminer que la plage fréquentielle la plus représentative de la réponse de la paroi 401 en fonction de la proportion d'air dans le mélange était comprise entre 30 et 300 Hz dans l'exemple étudié.

Ainsi, selon le premier mode de réalisation de l'invention, on identifie l'instant correspondant à un choc dans le signal mesuré. L'instant d'un choc peut par exemple être identifié à partir d'un pic du signal mesuré.

Une fois un instant d'un choc mesuré, la comparaison du signal acoustique mesuré comprend :

- la génération du spectrogramme temporel du signal acoustique à partir d'une durée prédéfinie postérieure à l'instant du choc identifié ;
- la comparaison du spectrogramme temporel généré à un modèle de spectrogramme temporel de référence, pour un signal acoustique correspondant à un mélange gazeux présentant une proportion prédéfinie d'air et du gaz isolant 41, pour une même géométrie de conteneur 40. Le spectrogramme temporel de référence correspond à un signal acoustique de référence à partir d'une même durée prédéfinie postérieure à l'instant d'un choc.

On détermine que le mélange gazeux dans le conteneur présente la proportion prédéfinie d'air et de gaz isolant 41 correspondant à un spectrogramme de référence si il y a une similitude suffisante entre ce spectrogramme de référence et le spectrogramme généré à partir du signal acoustique généré.

Pour l'exemple pratique illustré à la figure 3, on génère un spectrogramme temporel pour différents chocs correspondant aux rectangles entourés en trait discontinu. Les spectrogrammes temporels sont ainsi générés pour un choc sur une plage de fréquence comprise entre 30 et 300 Hz. Avantageusement, les spectrogrammes temporels seront générés sur une plage de fréquence incluant au moins une plage allant de 40 à 150 Hz. Avantageusement, suivant les configurations de conteneur 40, les spectrogrammes peuvent être réalisés sur une plage de fréquence comprise entre 30 et 1000 Hz. De préférence, les spectrogrammes temporels sont générés avec un filtrage passe bas, avec une fréquence de coupure de 1000 Hz. Les spectrogrammes temporels sont également générés pour un choc sur une période comprise entre 160 et 360 ms après ce choc. Un spectrogramme temporel correspondant est illustré à la figure 4. Avantageusement, la durée prédéfinie après le choc à partir de laquelle le spectrogramme temporel est réalisé est au moins égale à 100ms, de préférence au moins égale à 130ms. Avantageusement, la durée prédéfinie après le choc à partir de laquelle le spectrogramme temporel est réalisé est au plus de 250ms pour limiter la durée d'analyse. Des tests ont cependant montré que des informations significatives pour la composition du gaz étaient contenues dans des signaux acoustiques d'une durée de 7 à 8 secondes.

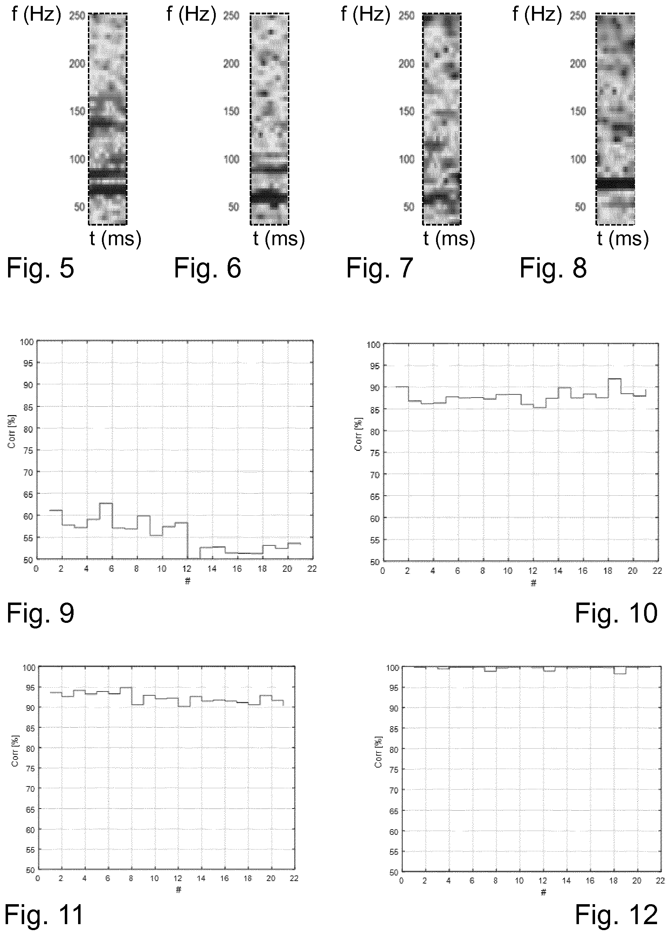

Les figures 5 à 8 illustrent des spectrogrammes temporels de référence correspondants, pour différentes compositions de mélanges d'air et de gaz isolant 41.

La figure 5 correspond ainsi au spectrogramme temporel de référence lorsque le conteneur 40 contient un gaz constitué à 100% de $SF_6$. La figure 6 correspond ainsi au spectrogramme temporel de référence lorsque le conteneur 40 contient un gaz comprenant 85% de $SF_6$ et 15% d'air. La figure 7 correspond ainsi au spectrogramme temporel de référence lorsque le conteneur 40 contient un gaz comprenant 70% de $SF_6$ et 30% d'air. La figure 8 correspond ainsi au spectrogramme temporel de référence lorsque le conteneur 40 contient un gaz comprenant 58% de $SF_6$ et 42% d'air.

Pour fiabiliser le procédé de détermination de la proportion d'air dans le mélange gazeux, on peut multiplier les chocs pour lesquels un signal acoustique est mesuré, afin de pouvoir éliminer ceux qui pourraient être entachés d'erreur. On peut par exemple réaliser entre 15 et 20 chocs sur la paroi 401.

On peut réaliser un spectrogramme temporel sur une plage de fréquence prédéfinie et pendant une période prédéfinie après le choc, pour chacun des signaux acoustiques mesurés.

On peut réaliser un spectrogramme temporel correspondant à une moyenne de plusieurs spectrogrammes temporels issus du signal acoustique mesuré, afin que ce spectrogramme temporel moyen soit bien représentatif d'un ensemble de mesures postérieures à différents chocs.

La comparaison d'un spectrogramme temporel généré à partir du signal acoustique mesuré à un spectrogramme temporel de référence peut être réalisée par une corrélation bidimensionnelle (axes de temps et de fréquence) entre ce spectrogramme temporel généré et un spectrogramme temporel de référence.

Les figures 9 à 12 illustrent les résultats de corrélation bidimensionnelle entre des spectrogrammes temporels de référence, et des spectrogrammes temporels réalisés pour plusieurs chocs sur une paroi 401 d'un même conteneur 40, incluant un mélange de 58% de $SF_6$ et de 42% d'air.

La figure 9 correspond à une corrélation bidimensionnelle entre le spectrogramme temporel de référence de la figure 5, et différents spectrogrammes temporels générés à partir de la mesure de signal acoustique pour plusieurs chocs sur la paroi 401. La valeur moyenne de corrélation bidimensionnelle est de 55,4% avec un écart type de 3,6%.

La figure 10 correspond à une corrélation bidimensionnelle entre le spectrogramme temporel de référence de la figure 6, et les différents spectrogrammes temporels générés à partir de la mesure de signal acoustique. La valeur moyenne de corrélation bidimensionnelle est de 87,8% avec un écart type de 1,5%.

La figure 11 correspond à une corrélation bidimensionnelle entre le spectrogramme temporel de référence de la figure 7, et les différents spectrogrammes temporels générés à partir de la mesure de signal acoustique. La valeur moyenne de corrélation bidimensionnelle est de 92,2% avec un écart type de 1,3%.

La figure 12 correspond à une corrélation bidimensionnelle entre le spectrogramme temporel de référence de la figure 8, et les différents spectrogrammes temporels générés à partir de la mesure de signal acoustique. La valeur moyenne de corrélation bidimensionnelle est de 99,6% avec un écart type de 0,4%.

La comparaison permet ici de déterminer sans ambiguïté que le spectrogramme temporel de référence le plus proche est bien celui du conteneur de référence incluant 58% de $SF_6$ et de 42% d'air. Les tests ont ainsi permis de vérifier que la proportion d'air dans le conteneur 40 avait pu être identifiée avec précision. L'écart, tant en valeur moyenne qu'en écart-type par rapport aux comparaisons avec d'autres spectrogrammes temporels de référence est assez significatif.

Pour vérifier la faible dépendance du procédé face aux dispersions de fabrication des équipements électriques 4, des tests ont été effectués sur plusieurs équipements électriques 4 de même type avec une même composition du gaz dans le conteneur 40. Les tests ont permis de confirmer une très grande cohérence des tests effectués avec ces différents équipements électriques.

Pour déterminer la fiabilité des paramètres du choc, on peut prévoir de réaliser un calcul de corrélation (dans le temps ou en fréquence) entre un signal vibratoire enregistré par exemple par l'outil 3, et le signal acoustique mesuré.

Le procédé de détermination selon le premier mode de réalisation semble particulièrement adapté avec des parois 401 en acier inoxydable présentant un module d'élasticité compris entre 200 et 330 MPa et/ou une dureté comprise entre HRB 75 et HRB 80, par exemple un acier 304L (ayant une dureté HRB 79).

La génération d'un spectrogramme temps-fréquence à partir du signal acoustique mesuré peut être effectuée par une transformée de Fourier de type STFT (pour Short Term Fourier Transform en langue anglaise), définie par exemple de la façon suivante :

$$STFT\{x[n]\}(m,\omega) = X[m,\omega] = \sum_{n=-\infty}^{+\infty} x[n] \cdot wind[n-m] \cdot e^{-j\omega n}$$

Avec X[m,ω] la transformée de Fourier STFT, m et w étant des variables discrétisées en temps (m) et en fréquence (w) de la STFT, x[n] étant le signal acoustique mesuré dans le temps, n étant le temps discret, wind[] étant une fenêtre temporelle glissante utilisée pour choisir et pondérer le sous-ensemble des échantillons sur lequel estimer la transformée STFT. La fenêtre peut être de différents types (par exemple Hamming, Hanning, Rectangulaire, Gaussienne) et a un impact sur la variance et la polarisation de l'estimation de la transformée de Fourier STFT.

Si on fixe le temps (m) et si on se concentre sur la simple fenêtre, la densité spectrale de puissance (par exemple sous forme de périodogramme simple) peut être calculée comme le module au carré de la transformée STFT. La densité spectrale peut bien entendu être normalisée par rapport à l'énergie totale de la fenêtre elle-même :

$$P_{X,\ norm}(\omega) = \frac{|X[\omega]|^2}{\sum_{\omega=0}^{\omega s/2}|X[\omega]|^2}$$

où X[ω] est la transformée STFT en ayant fixé le temps (m). La somme Σ calcule l'énergie totale du signal de la fenêtre temporelle sur l'intervalle [0 - ωs/2] (avec ws = 2π * fs, fs étant la fréquence d'échantillonnage du signal acoustique mesuré).

Comme le temps évolue, on calcule Px, norm (w) instant par instant et on le stocke dans les colonnes d'une matrice, correspondant au spectrogramme temporel :

$$Spectrogram(m,\omega) = P_{X,\ norm}(m,\omega)$$

avec Px,norm (m,w) le périodogramme simple normalisé, calculé à chaque instant discret m. Ce type de spectrogramme temporel normalisé permet de suivre l'évolution temporelle du spectre fréquentiel complet du signal acoustique mesuré.

La corrélation bidimensionnelle entre le spectrogramme temporel du signal acoustique mesuré et un spectrogramme temporel de référence peut être calculée suivant les étapes de procédé suivantes :
On calcule une corrélation croisée entre les spectrogrammes, soit dans le domaine spatial, soit dans le domaine fréquentiel. Le choix du domaine spatial ou fréquentiel est par exemple réalisé en fonction de la dimension du spectrogramme temporel de référence.

On calcule des sommes locales en prétraitant des sommes courantes.

On utilise des sommes locales pour réaliser la normalisation de la corrélation croisée pour obtenir des coefficients de corrélation.

L'application peut mettre en oeuvre la formule suivante :

$$\gamma(u,v) = \frac{\sum\limits_{x,y}\left[f(x,y)-\bar{f}_{u,v}\right]\left[t(x-u,y-v)-\bar{t}\right]}{\left\{\sum\limits_{x,y}\left[f(x,y)-\bar{f}_{u,v}\right]^2\sum\limits_{x,y}\left[t(x-u,y-v)-\bar{t}\right]^2\right\}^{0.5}}$$

Avec

- f l'image correspondant au spectrogramme temporel.
- $\bar{t}$ La moyenne dans l'image correspondant au spectrogramme temporel
- $\bar{f}_{u,v}$ La moyenne de f(x,y) dans la zone du spectrogramme temporel.
- Lors du calcul du maximum absolu de la matrice de corrélation croisée bidimensionnelle normalisée, cette valeur représente le pourcentage requis pour estimer la corrélation entre chaque spectrogramme temporel de référence et chaque spectrogramme temporel associé à un choc.

Un deuxième mode de réalisation de l'invention vise à garantir une quantité de traitement réduite. Le deuxième mode de réalisation s'avère en outre particulièrement précis avec une paroi 401 en acier inoxydable présentant un module d'élasticité compris entre 200 et 330 MPa et/ou une dureté HRB comprise entre HRB 85 et HRB 90, par exemple un acier inoxydable 17-4 Mn (HRB 87).

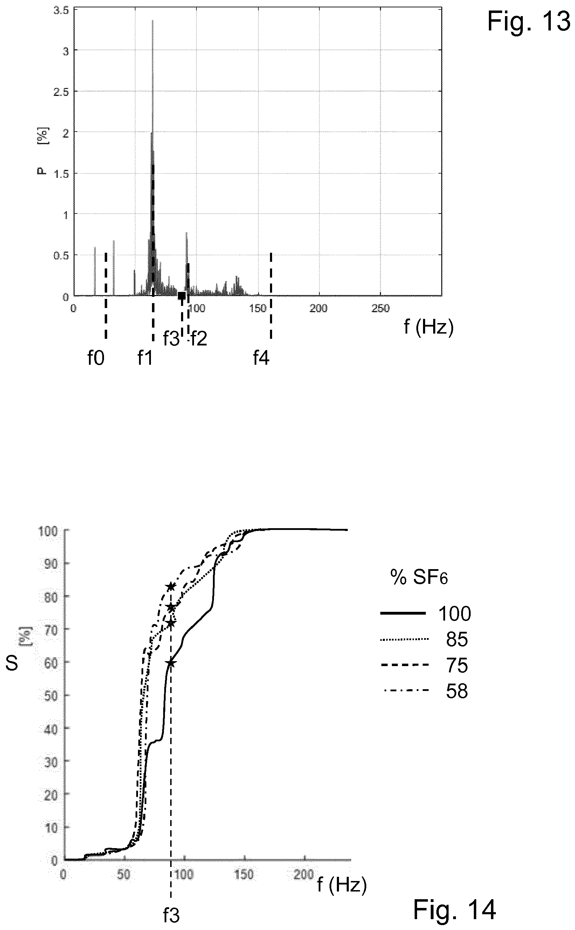

Selon le deuxième mode de réalisation, l'étape de comparaison du signal acoustique mesuré à un signal de référence est basée sur la décomposition spectrale du signal acoustique mesuré. Cette décomposition spectrale est exprimée en puissance en fonction de la fréquence. La figure 13 illustre un exemple de décomposition spectrale d'un signal acoustique mesuré en puissance P (ici à une échelle normalisée), pour une proportion d'air donnée dans un conteneur 40. On a ici mis en oeuvre un filtrage passe-bas à 300 Hz.

Sur cette décomposition spectrale, on peut identifier des pics de résonance, à des fréquences de résonance f1 et f2. On constate qu'à une fréquence f3 entre ces fréquences f1 et f2, la décomposition spectrale présente un creux significatif. Dans l'exemple, la fréquence f3 a une valeur de 88 Hz.

Pour cette fréquence f3, on va générer une sommation de puissance de la décomposition spectrale, cumulant la puissance pour les fréquences comprises :

- soit entre une même fréquence f0 et la fréquence f3;
- soit entre une même fréquence f4 et la fréquence f3 ;

Le cumul de puissance en partant soit d'une fréquence basse f0, soit d'une fréquence élevée f4 s'avère en effet représentatif de la proportion d'air dans le mélange incluant le gaz isolant 41.

La figure 14 illustre la sommation cumulative de la puissance acoustique en fonction de la fréquence, pour différents exemples de référence, avec des proportions d'air différentes dans le conteneur 40. Le conteneur 40 correspond ici à une première conception, avec une paroi 401 réalisée en acier inoxydable 304L. On note bien qu'entre les fréquences de résonance f1 et f2, et en particulier pour la fréquence f3, la sommation de la puissance acoustique présente un fort contraste en fonction des différentes proportions d'air. La sommation de la puissance acoustique à partir de la décomposition spectrale du signal acoustique mesuré permet donc d'identifier avec une grande fiabilité la proportion d'air dans le mélange incluant le gaz isolant 41.

Ainsi, en comparant la sommation générée pour la décomposition spectrale du signal acoustique mesuré avec les sommations des décompositions spectrales de référence, on peut déterminer quel échantillon de référence correspond à la proportion d'air dans le conteneur 40.

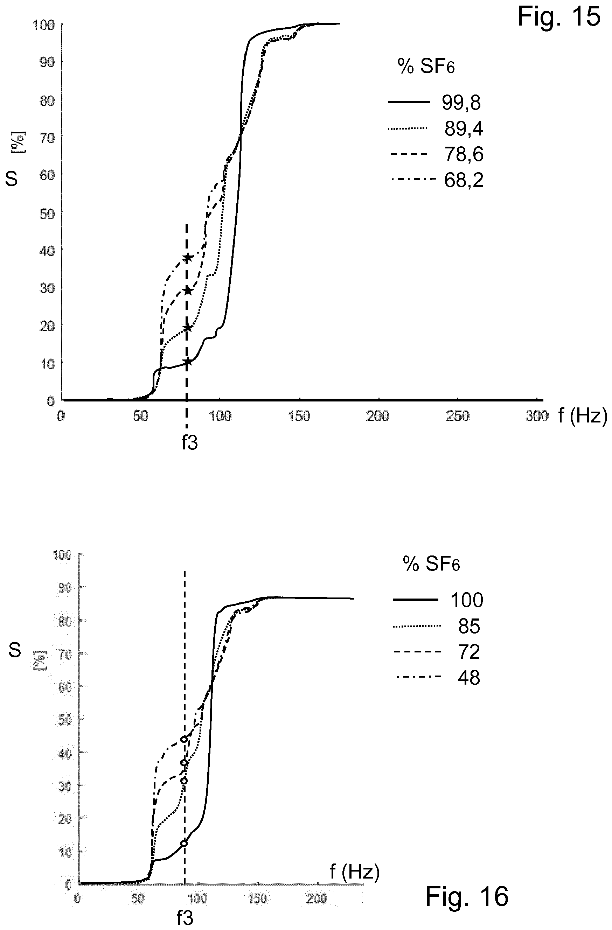

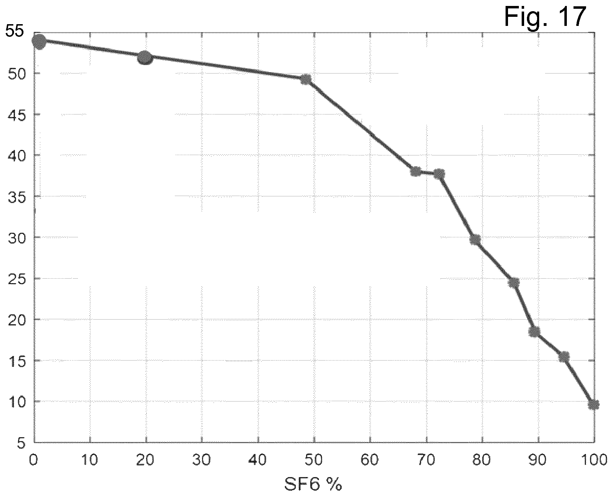

La figure 16 illustre une autre sommation cumulative de la puissance acoustique en fonction de la fréquence, pour différents exemples de référence, avec des proportions d'air (ou de gaz isolant) différentes dans le conteneur 40. Dans un souci de lisibilité, seul un nombre restreint d'exemples est illustré à la figure 16. Comme pour l'exemple précédant, on note que sur une plage de fréquence, et en particulier pour une fréquence f3 de 80Hz, la sommation de la puissance acoustique présente un fort contraste en fonction des différentes proportions d'air. Pour extrapoler avec précision la proportion d'air (ou de gaz isolant), on peut tracer une courbe caractéristique de cette proportion en fonction de la sommation cumulative à la fréquence f3. Ainsi, on peut relever les sommes cumulatives pour les différentes courbes à la fréquence f3, et les reporter dans un diagramme, tel qu'illustré à la figure 17, avec la proportion de gaz diélectrique en abscisse et la sommation cumulative de puissance acoustique en ordonnée. Une mesure de la sommation cumulative de puissance acoustique à la fréquence f3 permet donc d'extrapoler avec précision la proportion de gaz diélectrique dans le conteneur 40. On note dans cet exemple que la courbe de la figure 17 est assez linéaire au-delà de 50% de gaz diélectrique, et quasiment à saturation en dessous de 50% de gaz diélectrique.

Pour extrapoler la proportion de gaz diélectrique présente dans le conteneur 40, on récupère dans un premier temps la mesure de signal acoustique, comme détaillé précédemment. On réalise ensuite une décomposition spectrale exprimée en puissance en fonction de la fréquence, comme détaillé précédemment. On trace ensuite un diagramme de sommation de puissance en fonction de la fréquence, pour cette décomposition spectrale, comme détaillé précédemment. On obtient alors un diagramme tel qu'illustré à la figure 14. On relève alors la sommation cumulative à la fréquence f3. On recherche ensuite à quel point de la courbe de la figure 17 une telle sommation cumulative correspond, afin d'en déduire la proportion de gaz diélectrique dans le conteneur 40.

La décomposition spectrale du signal acoustique mesuré peut avantageusement être mise en oeuvre par transformation de Fourier, en particulier par transformation de type FFT. Avantageusement, le signal acoustique mesuré et soumis à la décomposition spectrale couvre plusieurs chocs appliqués sur la paroi flexible 401. Ainsi, la décomposition spectrale est effectuée sur une moyenne du signal sur plusieurs chocs, ce qui permet de minimiser l'influence des erreurs de mesure même avec des capacités de traitement réduite.

La figure 15 illustre la sommation de la puissance acoustique en fonction de la fréquence, pour différents exemples de référence d'une deuxième conception de conteneur 40. Le conteneur 40 présente ici une paroi 401 réalisée en acier inoxydable 17-4 Mn.

Comme pour l'exemple précédent, on peut constater que la sommation cumulative générée pour chacune des décompositions spectrales de référence pour un tel conteneur 40 est vraiment caractéristique de ce conteneur 40 pour la fréquence f3 comprises entre deux fréquences de résonance. Dans cet exemple, la fréquence f3 est ici d'environ 80 Hz.

On a ici mis en oeuvre un filtrage passe-bas à 300 Hz. Un tel filtrage permet de mieux identifier un creux ou un minimum entre deux fréquences de résonance de la décomposition spectrale du signal acoustique mesuré.

On peut éventuellement envisager d'utiliser le procédé pour déterminer la pression du gaz isolant, en comparant le signal acoustique mesuré à différents signaux acoustiques de référence pour différentes pressions de gaz isolant.

## Revendications

1. Procédé de détermination d'une proportion d'air dans un conteneur (40), le procédé comprenant :

   - la fourniture d'un équipement électrique (4) comprenant un conteneur étanche (40) contenant un gaz isolant (41) présentant une plus grande rigidité diélectrique que l'air et une masse molaire différente de celle de l'air, le conteneur (4) comportant une paroi flexible (401) formant membrane d'étanchéité pour le gaz isolant ;
   - l'application d'un choc sur le conteneur de façon à exciter la paroi flexible ;
   - la mesure (2) d'un signal acoustique à l'extérieur du conteneur après l'application du choc ;
   - l'identification (1) de l'instant du choc dans ledit signal acoustique mesuré ;
   - la comparaison (1) du signal acoustique après l'instant du choc identifié, à un signal acoustique de référence correspondant à un mélange gazeux présentant une proportion prédéfinie d'air et dudit gaz isolant ;
   - la détermination que le gaz dans le conteneur présente la proportion prédéfinie d'air et de gaz isolant à partir de la comparaison entre le signal acoustique mesuré et le signal acoustique de référence.

2. Procédé de détermination d'une proportion d'air selon la revendication 1, dans lequel :

   - ladite étape de comparaison du signal acoustique à un signal de référence comprend :

      - la génération d'un spectrogramme temporel dudit signal acoustique mesuré, à partir d'une durée prédéfinie postérieure à l'instant du choc identifié ;
      - la comparaison du spectrogramme temporel généré à un modèle de spectrogramme temporel de signal acoustique correspondant à un mélange gazeux présentant une proportion prédéfinie d'air et dudit gaz isolant.

3. Procédé de détermination d'une proportion d'air selon la revendication 2, dans lequel ladite paroi flexible (401) de l'équipement électrique fourni présente une fréquence de résonance fondamentale selon une direction normale à cette paroi comprise entre 30 et 1000Hz.

**4.** Procédé de détermination d'une proportion d'air selon la revendication 2 ou 3, comprenant une étape de génération dudit spectrogramme temporel dudit signal acoustique mesuré par une transformation de Fourier locale.

**5.** Procédé de détermination d'une proportion d'air selon l'une quelconque des revendications 2 à 4, dans lequel ladite comparaison des spectrogrammes temporels comprend une corrélation bidimensionnelle entre ces spectrogrammes temporels.

**6.** Procédé de détermination d'une proportion d'air selon l'une quelconque des revendications 2 à 5, dans lequel ladite durée prédéfinie est au moins égale à 100 ms.

**7.** Procédé de détermination d'une proportion d'air selon l'une quelconque des revendications 2 à 6, dans lequel ladite durée prédéfinie est au plus égale à 8 s.

**8.** Procédé de détermination d'une proportion d'air selon la revendication 1, dans lequel :

- ladite étape de comparaison du signal acoustique mesuré à un signal de référence comprend :

- la décomposition spectrale dudit signal acoustique mesuré, exprimée en puissance en fonction de la fréquence ;
- pour une fréquence $f3$ comprise entre deux fréquences de résonance $f1$ et $f2$ de la décomposition spectrale, la génération d'une sommation de puissance de la décomposition spectrale, cumulant la puissance pour les fréquences comprises entre :

- une même fréquence $f0$ et la fréquence $f3$ avec $f3 > f1 > f0$ ; ou
- une même fréquence $f4$ et la fréquence $f3$ avec $f4 > f2 > f3$ ;

- la comparaison de la sommation générée à une sommation de référence correspondant à un mélange gazeux présentant une proportion prédéfinie d'air et dudit gaz isolant.

**9.** Procédé de détermination d'une proportion d'air selon la revendication 8, dans lequel ladite décomposition spectrale est réalisée par transformée de Fourier.

**10.** Procédé de détermination d'une proportion d'air selon la revendication 8 ou 9, dans lequel ledit signal acoustique mesuré et décomposé spectralement couvre plusieurs chocs appliqués sur la paroi flexible.

**11.** Procédé de détermination d'une proportion d'air selon l'une quelconque des revendications précédentes, dans lequel ledit gaz isolant (41) présente une masse molaire au moins double de celle de l'air.

**12.** Procédé de détermination d'une proportion d'air selon la revendication 11, dans lequel ledit gaz isolant (41) fourni est du $SF_6$.

Fig. 1

Fig. 2

Fig. 3

Fig. 4

f (Hz)

Fig. 5

f (Hz)

Fig. 6

f (Hz)

Fig. 7

f (Hz)

Fig. 8

Fig. 9

Fig. 10

Fig. 11

Fig. 12

Fig. 13

% SF$_6$

— 100

········· 85

- - - - 75

-·-·- 58

Fig. 14

Fig. 15

Fig. 16

Fig. 17

**Europäisches Patentamt**
**European Patent Office**
**Office européen des brevets**

# RAPPORT DE RECHERCHE EUROPEENNE

Numéro de la demande

EP 18 18 0544

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | DATABASE WPI<br>Week 201371<br>13 février 2013 (2013-02-13)<br>Thomson Scientific, London, GB;<br>AN 2013-H90375<br>XP002779221,<br>-& CN 102 928 754 A (YUNNAN POWER GRID CO TECHNOLOGY BRANCH)<br>13 février 2013 (2013-02-13)<br>* le document en entier *<br>----- | 1-7,11, 12 | INV.<br>G01N29/036<br>G01N29/04<br>G01N29/14<br>G01N29/22<br>G01N29/38<br>G01N29/44<br>G01N29/46<br>G01N29/50<br>G01R31/12<br>G01R31/327 |
| Y | JP 2002 148133 A (TOYO SEIKAN KAISHA LTD)<br>22 mai 2002 (2002-05-22)<br>* alinéa [0002] *<br>* alinéas [0019] - [0030] *<br>* figures 1-6 *<br>----- | 1-4,6,7, 11,12 | H01H33/56<br>G01M3/00 |
| Y | US 4 187 718 A (SHIBASAKI KYUICHI [JP])<br>12 février 1980 (1980-02-12)<br>* colonne 1, lignes 6-13 *<br>* colonne 4, ligne 48 - colonne 13, ligne 39 *<br>* figures 1-15 *<br>----- | 1-3,5-7, 11,12 | |
| A | JP 2000 131180 A (MITSUBISHI ELECTRIC CORP) 12 mai 2000 (2000-05-12)<br>* alinéas [0008] - [0009], [0027], [0075] - [0077] *<br>----- | 1-12 | DOMAINES TECHNIQUES RECHERCHES (IPC)<br>G01N<br>G01R<br>H01H<br>G01M |
| A | JP H11 304631 A (TOYO SEIKAN KAISHA LTD)<br>5 novembre 1999 (1999-11-05)<br>* le document en entier *<br>----- | 1-12 | |

Le présent rapport a été établi pour toutes les revendications

| Lieu de la recherche | Date d'achèvement de la recherche | Examinateur |
|---|---|---|
| Munich | 31 octobre 2018 | Roetsch, Patrice |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 18 18 0544

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

31-10-2018

| Document brevet cité au rapport de recherche | | Date de publication | Membre(s) de la famille de brevet(s) | | Date de publication |
|---|---|---|---|---|---|
| CN 102928754 | A | 13-02-2013 | AUCUN | | |
| JP 2002148133 | A | 22-05-2002 | AUCUN | | |
| US 4187718 | A | 12-02-1980 | GB | 1594052 A | 30-07-1981 |
| | | | US | 4187718 A | 12-02-1980 |
| JP 2000131180 | A | 12-05-2000 | JP | 3472711 B2 | 02-12-2003 |
| | | | JP | 2000131180 A | 12-05-2000 |
| JP H11304631 | A | 05-11-1999 | JP | 3409692 B2 | 26-05-2003 |
| | | | JP | H11304631 A | 05-11-1999 |

EPO FORM P0460

Pour tout renseignement concernant cette annexe : voir Journal Officiel de l'Office européen des brevets, No.12/82

**RÉFÉRENCES CITÉES DANS LA DESCRIPTION**

**Documents brevets cités dans la description**

- WO 2011119335 A